# EUROPEAN PATENT APPLICATION

(11) **EP 1 683 758 A1**
(43) Date of publication of application: **26.07.2006**
(21) Application number: 04792234.9
(22) Date of filing: 08.10.2004
(51) Int. Cl.: C01B 6/21, C01B 6/24, C01B 21/092, C01B 3/00

(54) **LIGHT ELEMENT COMPLEX HYDRIDE FILM AND METHOD FOR SYNTHESIS THEREOF**

(30) Priority: 10.10.2003 JP 2003352958
(71) Applicant: Japan Science and Technology Agency, Kawaguchi-shi, Saitama 332-0012 (JP)
(72) Inventor: ORIMO, Shin-ichi, Sendai-shi, Miyagi 982-0841 (JP); NAKAMORI, Yuko, Sendai-shi, Miyagi 984-0803 (JP); YOKOYAMA, Masaki, Akashi-shi, Hyogo 673-0005 (JP); YAMAGISHI, Tetsuto, Nukata-gun, Aichi, 444-0104 (JP)
(74) Representative: Ebner von Eschenbach, Jennifer
(86) International application number: PCT/JP2004/014966
(87) International publication number: WO 2005/035440

(57) **Abstract**

The present invention provides a complex hydride (such as LiBH₄ or LiNH₂) of a lightweight metal thin film having a low melting point, and to a method for manufacturing the same, and the present invention relates to a method for manufacturing a thin film of a complex hydride having a nano structure, by vapor deposition, using as raw materials one or more metals selected from among lightweight metals having a low melting point (such as Li, Na, Mg, K, and Ca) and one or more elements selected from among nitrogen, carbon, boron, and aluminum, and to a light element complex hydride thin film, and with the method of the present invention, it is possible conveniently to form a thin film of a complex hydride of a lightweight metal having a low melting point, and a complex hydride thin film thus formed is useful, for example, as a multi-functional material having superconductivity, optical characteristics, hydrogen storage characteristics, and the like.

## Description

### TECHNICAL FIELD

The present invention relates to a light element complex hydride film, and to a method for manufacturing the same, more particularly to a method for synthesizing a novel light element complex hydride film composed of a thin film of a complex hydride having a nano structure, using as raw materials lithium, sodium, magnesium, or another such lightweight metal having a low melting point, and nitrogen, carbon, boron, aluminum, or the like, and to a novel light element complex hydride thin film composed of a homogeneous phase.

In the technological fields of the production and application of light element complex hydrides, typified by LiBH₄ and LiNH₂, which are expected to have a variety of functions such as hydrogen storage characteristics, hydrogen permeability, superconductivity, atomic power and nuclear fusion-related characteristics, and optical characteristics, these materials have been synthesized mainly in powder and bulk form up to now, but there has been no method for efficiently synthesizing a light element complex hydride thin film. In light of this, the present invention provides a novel method for manufacturing a complex hydride film with which it is possible to synthesize a thin film of a complex hydride having a nano structure, and a complex hydride film with a nano structure manufactured by this method.

The present invention involves the use of a complex hydride such as LiBH₄ or LiNH₂ in the form of a thin film, which, as a hydrogen storage-related technology, for example, increases the amount of hydrogen at the controlled grain boundary and lowers the reaction temperature, and as a superconductivity-related technology, raises the density of hydrogen in a two-dimensional plane and thereby forms a conduction band, and is useful for providing a novel complex hydride film material that allows these various functions to be realized and makes possible materials that are superconductive at close to room temperature and can be made into super-thin films for hydrogen purification devices and hydrogen tanks, for example.

### BACKGROUND ART

Research and development into alternative energy sources such as nuclear fusion, solar power, wind power, geothermal power, and fuel cells have been conducted in an effort to find new energy sources that can replace fossil fuels. These alternative energy sources are extracted either as heat or as electric power converted from heat, but since heat and electric power are difficult to store, there has been research aimed at storing these in the form of hydrogen. Fuel cells, in which hydrogen is used as a fuel, have been the subject of research and development because they can generate electricity with less impact on the global environment, and some of these have even reached the practical stage in applications ranging from power stations to consumer use. Hydrogen storage materials have been attracting attention as a new energy source because they afford smaller fuel cells, for example, and there has been a particularly strong need for the development of new hydrogen storage materials and the practical implementation of hydrogen storage and supply technology.

Thus, hydrogen is a substance that occupies an important position in the energy cycle as a next-generation energy source, and there are great hopes for its practical use. Examples of methods for the storage and supply of hydrogen that have undergone research and development up to now include hydrogen occlusion alloys; liquefied hydrogen and highpressure hydrogen; the hydrolysis and pyrolysis of inorganic complex compounds (such as borohydrides and aluminum hydrides); and the reformation of organic compounds (such as methanol, decalin, dimethyl ether, gasoline, and natural gas). Of these, light element complex hydrides have mainly been manufactured and studied in the form of a powder or bulk in the past.

Meanwhile, in fields of cutting-edge technology, the development of new substances and materials has in recent years become an extremely important part of basic technology supporting industry and scientific technology over a wide range of fields such as electronics, environmental and energy policies, biotechnology, and so forth. Examples of these are fine substances such as nano-sheets, fullerenes, and carbon nanotubes, which have been found to have novel characteristics that do not manifest themselves in bulk form. As new and excellent substances and materials have been discovered, and these have been revealed to exhibit distinctive structures and superior properties, there has been particularly keen interest in nano structure substances, viewed as substances that can serve as the most important basic materials for supporting nanotechnology, and particularly technology for the synthesis of these substances and research and development into the multi-functionality thereof.

In the midst of this, there have been various reports dealing with technology involving nano-substances as substances pertaining to the storage and supply of hydrogen. For instance, previous publications include the following. (1) There have been reported a magnesium-based hydrogen occlusion alloy material and a method for manufacturing the same, with which the solid solution content of hydrogen is high and the hydrogen release commencement temperature is low, and which are produced in a ball mill to achieve a microstructure on the nanometer scale (Japanese Laid-Open Patent Publication No.H11-61313/1999). (2) There has been reported a method for storing hydrogen in what are known as carbon nanotubes, produced by rolling a sheet of graphite into a cylinder (Japanese Laid-Open Patent Publication No.H11-116219/1999). This technology relates to a method for storing hydrogen in microtubular graphite and to capping the tubes with an alloy through which hydrogen readily passes. (3) It has been reported that a hydrogen store capable of storing more hydrogen that a conventional hydrogen occlusion alloy can be manufactured by using high-purity graphite and reducing it in size to a nano structure by mechanical pulverization (Japanese Laid-Open Patent Publication No.2001-302224). These hydrogen occlusion alloys, however, are limited to those intended mainly for use in bulk or powder form.

(4) There have been reported an Mg-Ni-based hydrogen occlusion alloy and a method for manufacturing the same, with which constituent elements are partially replaced with other metal elements so as to stabilize the crystal structure, so that phase separation or structural phase transition can be controlled in the occlusion and release of hydrogen (Japanese Laid-Open Patent Publication No.H11-269586/1999). Other previous publications discuss thin films of hydrogen occlusion alloys. (5) There have been reported a hydrogen occlusion laminated structure, and a method for producing the same, composed of Mg or a Mg-based hydrogen occlusion alloy having a nano structure, supporting a large amount of hydrogen occlusion, and having a low hydrogen release temperature, which is obtained by hydrogenating a magnesium-based laminated structure produced by sputtering (Japanese Laid-Open Patent Publication No.2002-105576). (6) As a result of a statistical examination of the mechanical properties, hydrogen occlusion characteristics, structure, and composition of a thin film produced by high-frequency magnetron sputtering of an LaNi₅ hydrogen occlusion alloy, it has been reported that this thin film occludes hydrogen more readily than a bulk alloy does (see http://www.iamp.tohoku.ac.jp/institute/activity/reports/1998/gas-j.html (9/30/2003)). (7) There has been a report into fuel cells involving hydrogen occlusion using sodium borohydride (NaBH₄) (see http://merit.jp.hydorogen.co. jp/Arai07.html (9/30/2003)). Nevertheless, so far no reports have been found dealing with making a thin film from a complex hydride.

### DISCLOSURE OF THE INVENTION

In light of the prior art discussed above, the inventors conducted diligent and repeated research aimed at developing a new high-functionality material that makes use of a complex hydride, and as a result succeeded in establishing a method for synthesizing a complex hydride film using as raw materials a lightweight metal having a low melting point, such as lithium, sodium, or magnesium, and nitrogen, carbon, boron, aluminum, or the like, and also discovered that the complex hydride film thus produced can serve as a novel material exhibiting various functions such as superconductivity, optical characteristics, hydrogen storage characteristics, hydrogen permeability, and atomic power and nuclear fusion-related characteristics. Further research led to the perfection of the present invention.

It is an object of the present invention to provide a light element complex hydride film and a method for manufacturing this film. It is another object of the present invention to provide a method for conveniently and efficiently producing a light element complex hydride film. It is another object of the present invention to provide a multi-functional complex hydride film material having improved characteristics over those of a bulk or powder material, by synthesizing a thin film of a complex hydride with a nano structure. It is another object of the present invention to provide a novel complex hydride film material that is useful as a hydrogen occlusion material capable of lowering the reaction temperature and increasing the amount of hydrogen at the controlled grain boundary. It is yet another object of the present invention to provide a novel complex hydride film material that is useful as a superconductive material capable of raising the density of hydrogen in a two-dimensional plane and thereby forming a conduction band.

The present invention that solves the above problems is a complex hydride film comprising a light element complex hydride film with a homogeneous phase of a nano structure, composed of a lightweight metal having a low melting point, elemental hydrogen, and one or more elements selected from among nitrogen, carbon, boron, and aluminum. As the favorable aspects of this invention, (1) the complex hydride film has on a substrate a thin film with a nano structure, composed of lightweight metal having a low melting point and one or more elements selected from among nitrogen, carbon, boron, and aluminum, and said thin film comprises of a hydrogenated homogeneous phase of complex hydride, (2) the lightweight metal having a low melting point is one or more metals selected from among alkali metals and alkaline earth metals, (3) the alkali metal or alkaline earth metal is one or more metals selected from lithium, sodium, magnesium, potassium, and calcium, (4) the film thickness is from 10 to 500 µm, and (5) the complex hydride film comprises a complex hydride of LiNH₂, LiBH₄, LiCH₃, Mg(NH₂)₂, or Mg(AlH₄)₂. The present invention is also a hydrogen storage material comprising the above-mentioned complex hydride film.

The present invention is also a method for manufacturing a complex hydride film, comprising the steps of (a) forming on a substrate a thin film having a nano structure composing of a lightweight metal having a low melting point and nitrogen, carbon, boron, or aluminum, by vapor deposition in a prescribed reaction vessel, using these elements as the raw materials, (b) introducing hydrogen gas into the reaction system to hydrogenate the thin film, and (c) synthesizing a light element complex hydride thin film composed of a homogeneous phase by the above steps, in a method for manufacturing a light element complex hydride. As the favorable aspects of this invention, (1) a lightweight metal having a low melting point and one or more elements selected from among nitrogen, carbon, boron, and aluminum are heated and evaporated to form a thin film having a nano structure of the elements on a substrate, (2) a lightweight metal having a low melting point is vapor deposited on a substrate in an atmosphere containing a prescribed amount of one or more elements selected from among nitrogen, carbon, boron, and aluminum, and thereby a thin film having a nano structure containing these elements is formed on the substrate, (3) hydrogen gas is introduced into the reaction system during or after the formation of the thin film, and thereby the thin film is hydrogenated, (4) the lightweight metal having a low melting point is one or more metals selected from among alkali metals and alkaline earth metals, (5) the alkali metal or alkaline earth metal is one or more metals selected from lithium, sodium, magnesium, potassium, and calcium, (6) the lightweight metal having a low melting point is vaporized by vacuum heating, sputtering, ion plating, or laser ablation, and thereby a thin film having a nano structure is formed on a substrate, (7) the thin film is formed at a temperature of from 300 to 800°C, and (8) the thin film and the hydrogen gas are brought into contact at a temperature of from 100 to 800°C.

The present invention will now be described in further detail.

The present invention is characterized in that a thin film of a complex hydride with a nano structure is synthesized by vapor deposition in a prescribed reaction vessel, using, as the raw materials, one or more metals selected from among lightweight metals having a low melting point, such as lithium, sodium, and magnesium, and one or more elements selected from among nitrogen, carbon, boron, aluminum. With the present invention, an alkali metal or alkaline earth metal, and preferably a metal such as lithium, sodium, magnesium, potassium, or calcium, and an element such as nitrogen, carbon, boron, or aluminum, are used as the raw materials. With the present invention, a complex hydride thin film is synthesized by mixing an element selected from among nitrogen, carbon, boron, and aluminum with a lightweight metal having a low melting point selected from among alkali metals and alkaline earth metals, and heating and evaporating this mixture, or by evaporating the above-mentioned lightweight metal having a low melting point in an atmosphere containing a prescribed amount of an element selected from among nitrogen, carbon, boron, and aluminum, thereby forming a thin film containing these elements on a substrate, and hydrogenating this thin film either during or after the formation.

The complex hydride film of the present invention is usually synthesized on a substrate. Favorable examples of substrates include metals such as molybdenum, tantalum, and tungsten, or a ceramic or glass, but the substrate is not limited to these, and a suitable material can be chosen according to the intended use, field of utilization, and so forth. With the present invention, the desired complex hydride film can be synthesized by combining the above-mentioned raw materials as necessary, and the composition and characteristics of the complex hydride film that is synthesized can be varied according to the combination and proportions of the one or more metals selected from among lightweight metal having a low melting points such as lithium, sodium, and magnesium, and the one or more elements selected from among nitrogen, carbon, boron, and aluminum. Therefore, with the present invention, these metals and elements, the proportions thereof, and other such factors can be varied as necessary according to the desired complex hydride film that is to be obtained.

More specifically, the complex hydride film of the present invention is synthesized on a substrate by, for example, mixing nitrogen, carbon, boron, or aluminum with a metal such as lithium or magnesium, and heating and evaporating this mixture to form a film, or evaporating a metal such as lithium or magnesium in an atmosphere containing a prescribed amount of nitrogen, carbon, boron, or the like to form a film, and then immediately hydrogenating this film, or hydrogenating simultaneously with the formation of the film. Any ordinary film formation method and apparatus can be used to form the complex hydride film of the present invention. For example, a vacuum vapor deposition method such as resistance heating vapor deposition, electron beam vapor deposition, laser heating vapor deposition, or high-frequency heating vapor deposition, or a sputtering method such as ion beam sputtering or magnetron sputtering, or ion plating, laser ablation, or another such method can be used. The method can be suitably selected according to the properties of the raw materials used to form the complex hydride film and so forth, but the use of a vacuum vapor deposition method and apparatus involving resistance heating is preferable.

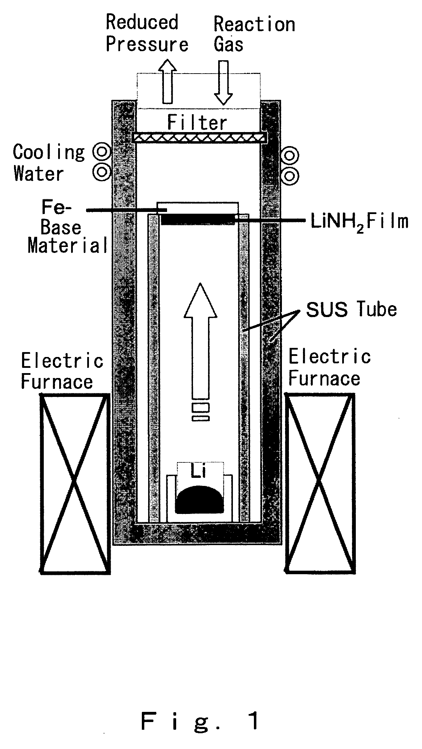

Next, a method and apparatus for synthesizing a complex hydride film by vacuum vapor deposition involving resistance heating will be described as an example through reference to FIG. 1.

This vacuum vapor deposition apparatus has a reaction chamber consisting of a stainless steel (SUS 304) reaction vessel capable of withstanding a vacuum or high pressure, and quartz tube that is held inside this reaction vessel. A crucible made of metallic molybdenum (molybdenum crucible) for holding a vapor deposition sample (such as lithium or magnesium), for example, is located at the bottom of the quartz tube, and a substrate (molybdenum substrate) for forming a vapor deposition film is disposed inside the quartz tube and above the crucible. A copper cooling pipe (copper pipe) is disposed at the top on the outside of the stainless steel reaction vessel, and a coolant (cooling water) is circulated through this pipe so that everything but the reaction chamber of the reaction vessel will be cooled and not reach a high temperature. A reaction gas introduction apparatus for adjusting the reaction atmosphere by introducing a reaction gas (such as hydrogen, nitrogen, or methane gas) into the reaction vessel, and a vacuum pump for reducing the pressure inside the reaction vessel, are connected higher up above the reaction vessel.

The portion of the reaction chamber containing the sample and substrate in the reaction vessel is held in an electric furnace, allowing the sample and substrate to be heated to the required temperature. A thermocouple is disposed in contact with the outer edge of the stainless steel reaction vessel, and the temperature indicated by this thermocouple is used as the reaction temperature. The crucible in which the sample is held is made of a material that can withstand the vapor deposition temperature and will not react with the sample. Examples of materials that will not react with the vapor deposited lithium, sodium, magnesium, or other metals include metallic molybdenum and metallic tungsten. These materials are preferably used in high purity form, such as about 99 to 99.99%. The above-mentioned vacuum vapor deposition apparatus basically just needs to have the function of forming a film by vapor depositing the sample on the substrate, and its specific configuration can be designed as desired and as dictated by the type of complex hydride film, the purpose of production, the scale of production, and other such factors.

The lithium, sodium, magnesium, or other metal used as the sample also preferably has a high purity of from 95 to 99.99%. The nitrogen, hydrogen, carbon (such as methane gas), or boron that is introduced as a vapor phase into the reaction vessel also preferably has a high purity of about 99.999%.

The boiling point at normal pressure of the lightweight metal having a low melting point is, for example, 1342°C for lithium, 883°C for sodium, and 1090°C for magnesium, but the boiling point under reduced pressure is lower than this, so the sample in the vacuum reaction vessel is usually heated to between approximately 300 and 800°C, and preferably approximately 500 and 700°C, for vacuum vapor deposition. The higher is the heating temperature, the higher is the vapor deposition pressure, so the higher the temperature, the faster the film is formed. How long the vapor deposition takes will vary with the desired film thickness, the evaporation pressure of the sample metal, the vapor deposition temperature, and so forth, but it usually takes approximately 1 to 5 minutes. If nitrogen or methane gas or the like is introduced into the reaction vessel during the evaporation of the metal in the reaction vessel, the evaporated metal will react with the nitrogen or methane or the like in the vapor phase, producing a metal nitride, metal carbide, or metal carbonitride, which will then be deposited in the form of a film on the substrate. Since the composition of the deposited film here varies with the metal evaporation pressure (that is, the vapor deposition temperature) and the gas pressure inside the reaction vessel, the composition of the film can be suitably varied by adjusting the heating temperature, the pressure of the introduced gas, and so forth. The gas pressure of the nitrogen, methane, or other gas introduced into the reaction vessel is usually approximately 0.2 to 0.5 MPa (approximately 2 to 5 atmospheres).

With the present invention, when boron or aluminum is used, for example, the lightweight metal having a low melting point can be mixed with the boron or aluminum and heated and evaporated in the crucible inside the reaction vessel, which makes it possible to form the reaction product of the two into a film. In an example of the method of the present invention for manufacturing a complex hydride film, a film composed of a metal selected from among alkali metals and alkaline earth metals and an element selected from among nitrogen, carbon, boron, and aluminum is formed on a substrate by vapor deposition, after which this film is brought into contact with hydrogen to create a complex hydride film. In the step of producing a hydride here, since the reaction proceeds rapidly under a high temperature, the hydrogenation may be performed in a state in which the inside of the reaction vessel is kept at the temperature at which the metal is vapor deposition, such as between 500 and 800°C. Also, the hydrogen introduced here is usually at a pressure of approximately 0.1 to 2.0 MPa, but a range of approximately 1.0 to 2.0 MPa is particularly favorable in terms of accelerating the reaction. The higher is the hydrogen pressure, the higher is the hydrogenation reaction rate, and producing a complex hydride film with a thickness of from 100 to 300 µm will take about 1 to 3 hours (contact time) when the temperature is approximately 200°C and the hydrogen pressure is approximately 1.0 MPa.

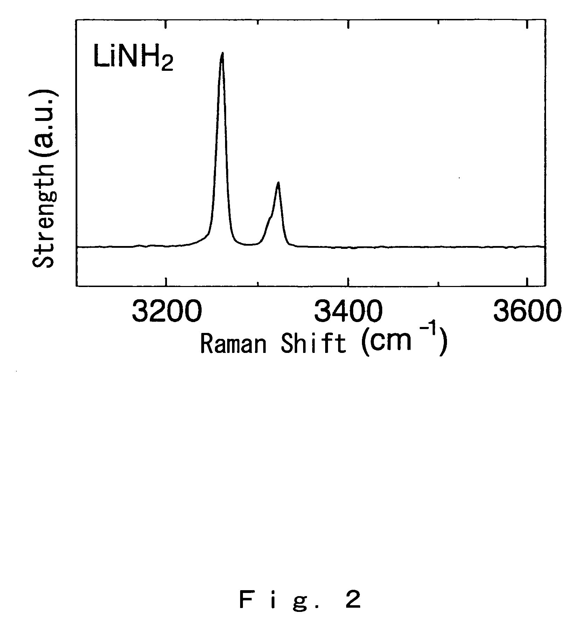

In another example of the method of the present invention for manufacturing a complex hydride film, the complex hydride is produced simultaneously with the formation of the film. When a lightweight metal having a low melting point, elemental hydrogen, and one or more elements selected from among nitrogen, carbon, boron, and aluminum are all present at the same time in gaseous form in the reaction vessel, they all react with each other and are deposited on the substrate, thereby immediately forming a complex hydride film on the substrate within the reaction vessel. This method requires that the inside of the reaction chamber be kept to a pressure of about 1 Pa. The complex hydride formed on the substrate is a thin film of about 10 to 500 µm, and the entire film was confirmed to be a homogeneous phase from the results of evaluating the arrangement of atoms other than hydrogen atoms and the oscillation mode of hydrogen atoms by Raman spectroscopy and powder X-ray diffraction. The results of Raman spectroscopy (see FIG. 2) also revealed an oscillation mode consisting of one nitrogen atom and two hydrogen atoms, which confirms that the film formed with the present invention is a complex hydride film having an LiNH₂ composition, for example. The present invention makes it clear that a film formed by the manufacturing method of the present invention is composed of a complex hydride composed of a homogeneous phase.

A complex hydride film with a nano structure can be synthesized with the present invention. A complex hydride thin film produced by the method of the present invention is composed of a homogeneous phase, and exhibits multi-functionality that could not be attained with a powder or bulk material. Specifically, with a thin film of LiBH₄, LiNH₂, or another such light element complex hydride produced by the method of the present invention, a homogeneous phase is readily formed, so controlling the arrangement of hydrogen atoms is easier than with a powder or bulk material, for example, and when this film is used as a hydrogen storage material, for instance, a lower reaction temperature and a larger amount of hydrogen at the controlled grain boundary can be anticipated, and when the film is used as a superconductive material, the formation of a conduction band by high-density hydrogen in a two-dimensional plane can be anticipated, which means that the present invention has special merits that cannot be anticipated with a conventional method.

The present invention relates to a novel light element complex hydride film composed of a thin film of a complex hydride having a nano structure and containing one or more metals selected from among lightweight metals having a low melting point, such as lithium, sodium, and magnesium, elemental hydrogen, and one or more elements selected from among nitrogen, carbon, boron, and aluminum, and to a method for manufacturing this film. With the present invention, (1) it is possible to synthesize thin films of complex hydrides having a nano structure and of various compositions, such as LiNH₂, LiBH₄, LiCH₃, Mg(NH₂)₂, or Mg(AlH₄)₂, using as raw materials a lightweight metal having a low melting point such as lithium, sodium, magnesium, potassium, or calcium, and nitrogen, carbon, boron, or aluminum, (2) a novel process for forming a complex hydride film can be provided, (3) the complex hydride film of the present invention can be synthesized by a simple thin film formation method involving vapor deposition, (4) the method of the present invention comprises simple steps, namely, a step of synthesizing a complex hydride thin film, and a hydrogenation step, (5) the complex hydride film produced with the present invention can be anticipated to serve as a novel hydrogen occlusion material that makes possible a lower reaction temperature and a larger amount of hydrogen at the controlled grain boundary, and (6) the complex hydride film produced with the present invention can be anticipated to serve as a novel superconductive material capable of raising the density of hydrogen in a two-dimensional plane and thereby forming a conduction band.

### BRIEF DESCRIPTION OF THE DRAWINGS

FIG. 1 illustrates an example of the vapor deposition apparatus used in Example;
FIG. 2 is a graph of data from measurement by Raman spectroscopy, indicating that the LiNH₂ complex hydride film produced in Example 1 is a homogeneous phase;
FIG. 3 is a graph of data from measurement by powder X-ray diffraction, indicating that the LiNH₂ complex hydride film produced in Example 1 has a homogeneous phase; and
FIG. 4 is a graph of gas chromatography data indicating that the hydrogen release commencement temperature of the LiNH₂ complex hydride thin film produced in Example 1 was about 50 degrees lower than that of a powder sample.

### BEST MODE FOR CARRYING OUT THE INVENTION

The present invention will now be described in specific terms on the basis of working examples, but the present invention is not limited in any way by these Examples.

### Example 1

In this example, an example of producing the complex hydride film of the present invention by using the vapor deposition apparatus shown in FIG. 1 will be described.

### (1) Apparatus

FIG. 1 shows a diagram of the configuration of the apparatus used in this example. This apparatus comprises a stainless steel (SUS 304) reaction vessel capable of withstanding a vacuum or high pressure, a line system for introducing a reaction gas (such as hydrogen, nitrogen, or methane) or putting the interior of the reaction vessel under a vacuum or pressurization, a molybdenum crucible (small vessel) for holding a sample (such as Li or Mg), a molybdenum substrate, a quartz tube for holding these, an electric furnace for heating the quartz tube from around its outside, a copper pipe through which circulates cooling water that cools the quartz tube, a thermocouple for measuring the temperature, and so on.

### (2) Measurement apparatus and conditions

### Raman spectroscopy

Measurement apparatus: Thermo Nicolet, made by Almega-HD

Measurement conditions: 532 nm laser microscope stage (room temperature, argon)

### X-ray diffraction

Measurement apparatus: RINT 2100, made by Rigaku

Measurement conditions: Cu-Kα line (room temperature, protective tape)

### (3) Synthesis of lithium-nitrogen-complex hydride

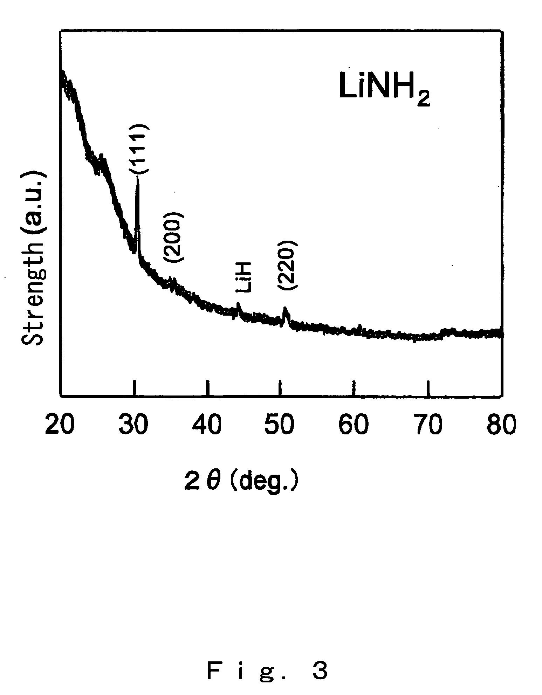

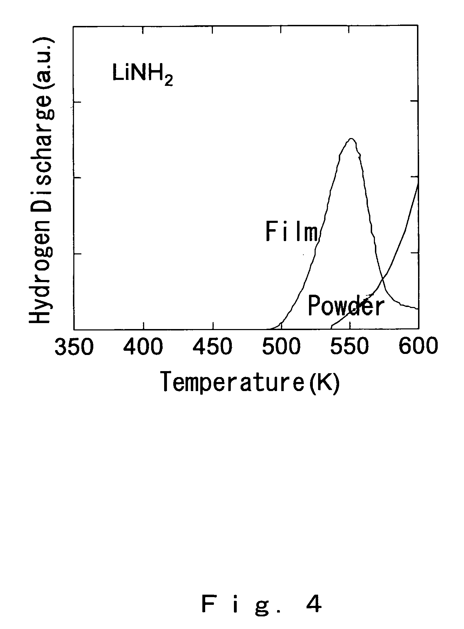

A metallic lithium sample (purity of 95%, made by Aldrich) weighing from 50 to 300 mg was placed in the molybdenum small vessel, and these were set in a stainless steel (SUS 304) reaction vessel capable of withstanding a vacuum or high pressure, in an argon glow box. A substrate composed of metallic molybdenum (purity of 99.9%, made by Nicolet) was disposed at the top inside the reaction vessel. The interior of this stainless steel reaction vessel was degassed under a vacuum, was introduced with high-purity nitrogen (5 Pa, purity of 99.9999%),was heated to 600°C under this atmosphere to perform a vapor deposition treatment for 10 minutes, and thereby a thin film of lithium nitride with a thickness of 50 to 200 µm was produced on the substrate. After this, under the temperature held the same, the interior of the vessel was introduced with hydrogen immediately at 1 MPa to promote a hydrogenation reaction and synthesize a lithium-nitrogen-complex hydride on the substrate. FIG. 2 shows the results of measuring the thin film thus produced by Raman spectroscopy. FIG. 3 shows data indicating that this thin film was a homogeneous phase. FIG. 4 is a graph of gas chromatography data indicating that the hydrogen release commencement temperature of the thin film produced in this working example was about 50 degrees lower than that of a powder sample.

### Example 2

### (1) Apparatus

The same apparatus as that used in Example 1 above was used.

### (2) Measurement apparatus and conditions

The same apparatus and conditions as those used in Example 1 above were used.

### (3) Synthesis of magnesium-nitrogen/carbon-complex hydride

100 mg of metallic magnesium was put in the molybdenum small vessel, and these were set in a stainless steel (SUS 304) reaction vessel capable of withstanding a vacuum or high pressure, in an argon glow box. A substrate composed of metallic molybdenum (purity of 99.9%, 10 mmφ in diameter) was disposed at the top inside the reaction vessel. The interior of this stainless steel reaction vessel was degassed under a vacuum, was introduced with a nitrogen/carbon mixed gas (mixing ratio of 10:1) at 5 Pa, was heated to 670°C under this atmosphere to perform a vapor deposition treatment for 5 minutes, and thereby a thin film of magnesium carbonitride with a thickness of 100 to 300 µm was produced on the substrate. After this, under the temperature held at 600°C, the interior of the vessel was introduced with hydrogen immediately at 3 MPa to promote a hydrogenation reaction and synthesize a magnesium-nitrogen/carbon-complex hydride on the substrate. The thin film thus produced was measured by Raman spectroscopy. It was also confirmed by power X-ray diffraction measurement that the film was a homogeneous phase.

### INDUSTRIAL APPLICABILITY

As detailed above, the present invention relates to a novel light element complex hydride film composed of a thin film of a complex hydride having a nano structure, composed of one or more metals selected from among lightweight metals having a low melting point, such as lithium, sodium, and magnesium, elemental hydrogen, and one or more elements selected from among nitrogen, carbon, boron, and aluminum, and to a method for manufacturing this film. With the present invention, thin films of complex hydrides having a nano structure can be synthesized using as raw materials a lightweight metal having a low melting point, such as lithium, sodium, magnesium, potassium, or calcium, and nitrogen, carbon, boron, or aluminum. The present invention provides a process for forming a novel complex hydride thin film having a nano structure. The complex hydride film produced with the present invention has an ability of hydrogen storage, which makes it possible to lower reaction temperature and increase amount of hydrogen, and is useful as a next-generation hydrogen storage material. Also, the complex hydride film produced with the present invention is useful as a next-generation superconductive material capable of forming a conduction band with high-density hydrogen in a two-dimensional plane.

## Claims

1. A complex hydride film **characterized by** comprising a light element complex hydride film with a homogeneous phase of a nano structure, the light element complex hydride is composed of a lightweight metal having a low melting point, elemental hydrogen, and one or more elements selected from among nitrogen, carbon, boron, and aluminum.

2. The complex hydride film according to Claim 1, wherein the film has on a substrate a thin film with a nano structure composed of lightweight metal having a low melting point and one or more elements selected from among nitrogen, carbon, boron, and aluminum, and said thin film comprises a hydrogenated homogeneous phase of the complex hydride.

3. The complex hydride film according to Claim 1, wherein the lightweight metal having a low melting point is one or more metals selected from among alkali metals and alkaline earth metals.

4. The complex hydride film according to Claim 3, wherein the alkali metal or alkaline earth metal is one or more metals selected from lithium, sodium, magnesium, potassium, and calcium.

5. The complex hydride film according to Claim 1, wherein the film thickness is from 10 to 500 µm.

6. The complex hydride film according to Claim 1, wherein the complex hydride film comprises a complex hydride of LiNH₂, LiBH₄, LiCH₃, Mg(NH₂)₂, or Mg(AlH₄)₂.

7. A hydrogen storage material, comprising the complex hydride film as defined in any of Claims 1 to 6.

8. A method for manufacturing a complex hydride film **characterized by** comprising the steps of:
(1) forming on a substrate a thin film having a nano structure composed of a lightweight metal having a low melting point, and nitrogen, carbon, boron, or aluminum, by vapor deposition in a prescribed reaction vessel, using the elements as the raw materials;
(2) introducing hydrogen gas into the reaction system to hydrogenate the thin film; and
(3) synthesizing a light element complex hydride thin film composed of a homogeneous phase by the above steps, in a method for manufacturing the light element complex hydride.

9. The method for manufacturing a complex hydride film according to Claim 8, wherein a lightweight metal having a low melting point and one or more elements selected from among nitrogen, carbon, boron, and aluminum are heated and evaporated to form a thin film having a nano structure of the elements on a substrate.

10. The method for manufacturing a complex hydride film according to Claim 8, wherein a lightweight metal having a low melting point is vapor deposited on a substrate in an atmosphere containing a prescribed amount of one or more elements selected from among nitrogen, carbon, boron, and aluminum, and thereby a thin film having a nano structure containing the elements is formed on the substrate.

11. The method for manufacturing a complex hydride film according to any of Claims 8 to 10, wherein hydrogen gas is introduced into the reaction system during or after the formation of the thin film, and thereby the thin film is hydrogenated.

12. The method for manufacturing a complex hydride film according to any of Claims 8 to 10, wherein the lightweight metal having a low melting point is one or more metals selected from among alkali metals and alkaline earth metals.

13. The method for manufacturing a complex hydride film according to Claim 12, wherein the alkali metal or alkaline earth metal is one or more metals selected from lithium, sodium, magnesium, potassium, and calcium.

14. The method for manufacturing a complex hydride film according to any of Claims 8 to 10, wherein the lightweight metal having a low melting point is vaporized by vacuum heating, sputtering, ion plating, or laser ablation, and thereby a thin film having a nano structure is formed on a substrate.

15. The method for manufacturing a complex hydride film according to any of Claims 8 to 10, wherein the thin film is formed at a temperature of from 300 to 800°C.

16. The method for manufacturing a complex hydride film according to Claim 8 or 11, wherein the thin film and the hydrogen gas are brought into contact at a temperature of from 100 to 800°C.
